# DEMANDE DE BREVET EUROPEEN

(11) **EP 0 962 971 A1**
(43) Date de publication de la demande: **08.12.1999**
(21) Numéro de dépôt: 99410076.6
(22) Date de dépôt: 03.06.1999
(51) Int. Cl.: H01L 21/8234, H01L 27/088

(54) **Procédé de fabrication de transistors haute et basse tension**

(30) Priorité: 03.06.1998 FR 9807124
(71) Demandeur: STMicroelectronics S.A., 94250 Gentilly (FR)
(72) Inventeur: Mirabel, Jean-Michel, 13480 Cabries (FR)
(74) Mandataire: de Beaumont, Michel

(57) **Abrégé**

L'invention concerne un procédé de fabrication de circuits intégrés comportant des transistors MOS haute et basse tension (HTN, LTN ; HTP, LTP). Ce procédé comporte des étapes de formation des structures de grilles isolées (2), de formation des régions de drain/source (5 ; 7), de dépôt d'une couche isolante (8), et comporte en outre les étapes suivantes : former un masque au-dessus, et en débordement latéral, des grilles des transistors haute tension ; graver la couche isolante de façon à laisser des espaceurs (9) sur les bords des grilles des transistors basse tension ; implanter un dopant adapté à former des régions (11 ; 13) de contact de drain/source de tous les transistors ; et former de façon auto-alignée une couche de siliciure métallique (15) sur les régions de contact drain/source de tous les transistors et sur les contacts de grille des transistors basse tension.

## Description

La présente invention concerne de façon générale le domaine de la fabrication des circuits intégrés. Plus particulièrement, la présente invention concerne la fabrication de transistors CMOS haute et basse tension dans un substrat semiconducteur, utilisables par exemple dans des dispositifs mémoire.

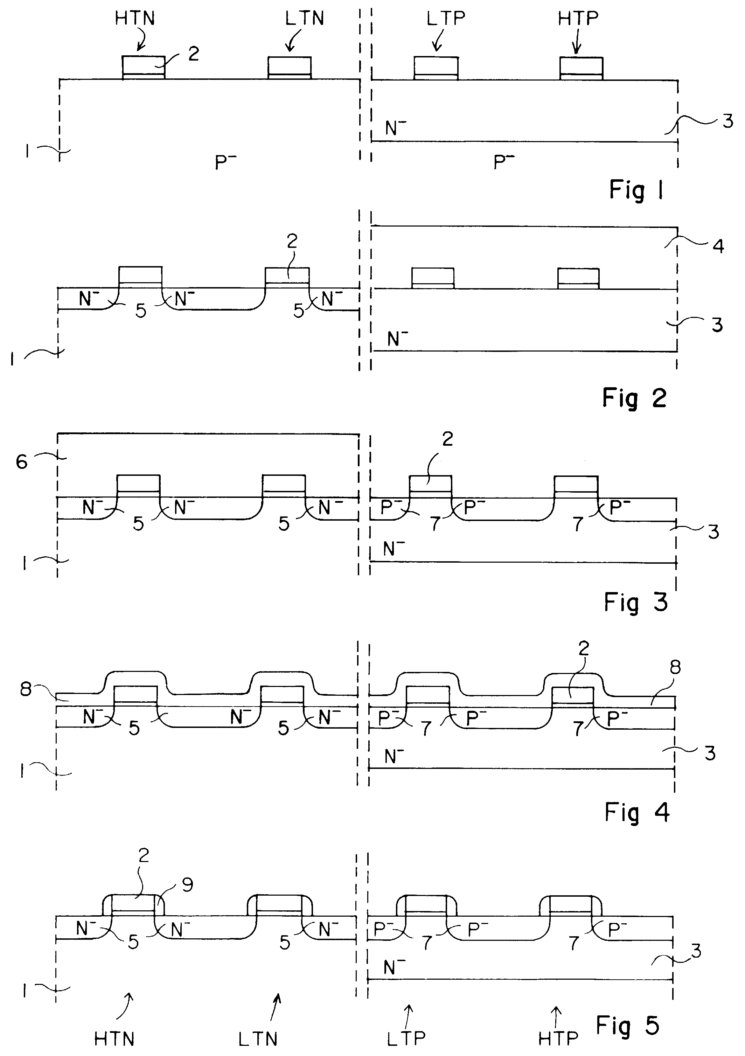

Les figures 1 à 9 illustrent de façon schématique et vues en coupe des étapes successives d'un procédé de fabrication de différents transistors MOS haute et basse tension sur un même substrat selon un procédé classique.

Comme l'illustre la figure 1, on considère un substrat 1 d'un premier type de conductivité, par exemple P, faiblement dopé dans lequel ont été formés des caissons 3 de type de conductivité opposé N, faiblement dopés. On notera que le terme substrat est utilisé ici pour désigner une région ou couche supérieure d'un composant semiconducteur, par exemple, un circuit intégré. On a également formé sur ce substrat, typiquement en silicium, plusieurs structures isolées 2 constituées d'une couche d'isolant, par exemple, de l'oxyde de silicium, et d'une couche semiconductrice, par exemple, en silicium polycristallin, destinées à former les grilles de chacun des transistors. Éventuellement, on prévoit un oxyde de grille plus épais pour les transistors haute tension que pour les transistors basse tension.

On souhaite former dans le substrat 1, dans la partie gauche des figures, un transistor à canal N haute tension HTN et un transistor à canal N basse tension LTN. On souhaite former dans le caisson 3, dans la partie droite des figures, un transistor à canal P haute tension HTP et un transistor à canal P basse tension LTP. Dans la suite de la présente description, on désignera par HTN, LTN, HTP ou LTP aussi bien un transistor achevé qu'une partie du substrat ou du caisson dans laquelle le transistor correspondant est en cours de formation.

On souhaite former des transistors de type LDD, parmi lesquels, pour les transistors haute tension, HTP et HTN, la région fortement dopée de prise de contact de drain/source est plus éloignée de la région de canal que pour des transistors basse tension, LTP et LTN.

A l'étape suivante, illustrée en figure 2, on forme une première couche de masquage 4, de façon à découvrir des parties du substrat dans lesquelles doivent être créés les transistors HTN et LTN. On réalise une implantation à faible dose d'un dopant de type N adapté à former des régions 5 faiblement dopées de drain et de source. Cette implantation sera appelée ci-après implantation LDD_{N}.

A l'étape suivante, illustrée en figure 3, on forme une deuxième couche 6 de masquage, de façon à découvrir les caissons 3 de type N dans lesquels doivent être créés les transistors HTN et LTN. On réalise une implantation à faible dose d'un dopant de type P adapté à former des régions 7 faiblement dopées de drain et de source. Cette implantation sera appelée ci-après implantation LDD_{P}.

A l'étape suivante, illustrée en figure 4, on dépose sur toute la structure (pleine plaque) une couche 8 d'isolant, typiquement de l'oxyde de silicium.

A l'étape suivante, illustrée en figure 5, on grave, sans masquage, la couche d'oxyde 8 de façon à ne laisser en place que des espaceurs latéraux 9 sur les bords des structures de grilles isolées 2 des transistors.

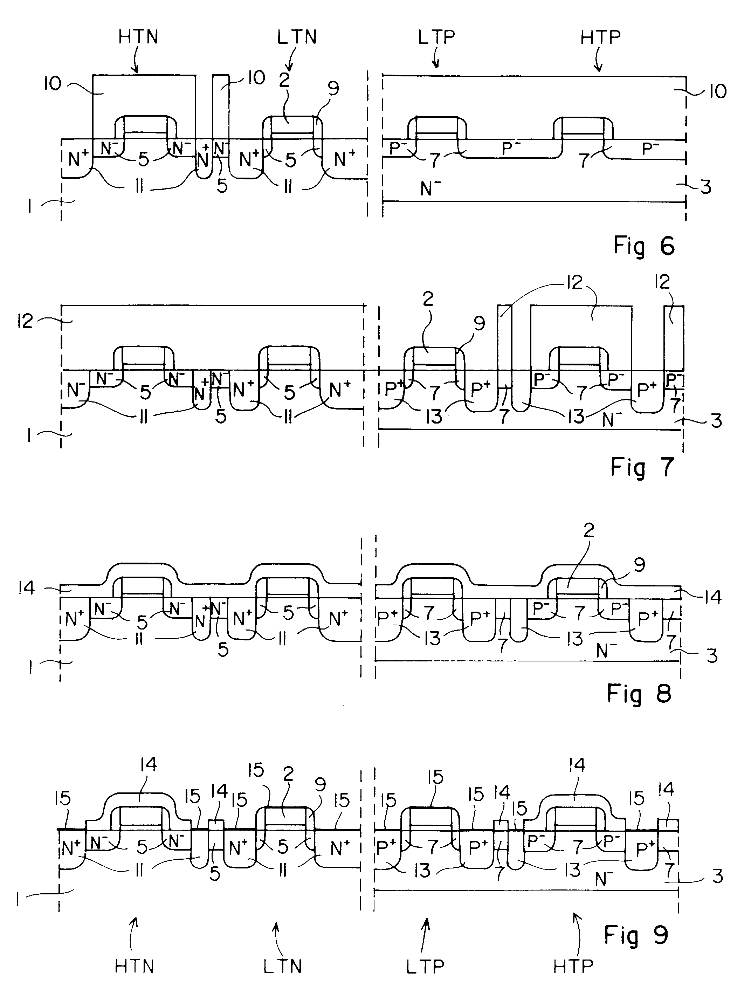

A l'étape suivante, illustrée en figure 6, on dépose une troisième couche de masquage 10. Le troisième masque 10 est gravé de façon à recouvrir complètement les zones des transistors à canal P, HTP et LTP, à découvrir complètement les zones des transistors basse tension LTN, et à recouvrir les grilles des transistors haute tension HTN en débordant latéralement par rapport à celles-ci. On procède alors à un dopage de type N à dose élevée, pour réaliser les régions 11 de prise de contact de drain/source fortement dopées de type N des transistors HTN et LTN. Le dessin du masque 10 est tel que ces régions 11 sont plus éloignées des grilles des transistors haute tension HTN que des grilles des transistors basse tension LTN. En effet, pour ces dernières la distance entre la projection de la grille et les régions de contact est fixée par les espaceurs 9. En outre, les régions de prise de contact de source/drain de deux transistors adjacents sont distinctes l'une de l'autre.

A l'étape suivante, illustrée en figure 7, on réalise de façon similaire les régions 13 de prise de contact de drain/source des transistors HTP et LTP. Pour cela, on dépose une quatrième couche de masquage 12. Le quatrième masque 12 est gravé de façon à recouvrir complètement les zones des transistors à canal N, HTN et LTN, à découvrir complètement les zones des transistors basse tension LTP, et à recouvrir les grilles des transistors haute tension HTP en débordant latéralement par rapport à celles-ci. On procède alors à un dopage de type P à dose élevée, pour réaliser les régions 13 de prise de contact de source/drain fortement dopées de type P des transistors HTP et LTP. Le dessin du masque 12 est tel que ces régions 13 sont plus éloignées des grilles des transistors haute tension HTP que des grilles des transistors basse tension LTP. En effet, pour ces dernières la distance entre la projection de la grille et les régions de contact est fixée par les espaceurs 9. En outre, les régions de prise de contact de source/drain de deux transistors adjacents sont distinctes l'une de l'autre.

A l'étape suivante, illustrée en figure 8, on dépose, pleine plaque, une couche 14 d'isolant, typiquement une structure multicouche, par exemple, de titane, de nitrure de titane et d'oxyde de silicium.

A l'étape suivante, illustrée en figure 9, on ouvre la couche 14 au-dessus des régions de contact drain/source de tous les transistors. Ensuite, on forme par recuit rapide à haute température une couche 15 de siliciure métallique, typiquement du siliciure de titane, sur toutes les surfaces apparentes de silicium. On notera que cette siliciuration est également effectuée sur les grilles des transistors basse tension, LTN et LTP.

Un inconvénient de ce procédé réside dans la gravure de la couche d'oxyde 8 destinée à former les espaceurs 9 des différents transistors, gravure effectuée après les implantations LDDN et LDDp. En effet, cette gravure attaque également la surface du substrat 1, ce qui détériore les régions sous-jacentes 5 et 7 faiblement dopées et peu profondes. Ceci est particulièrement gênant de part et d'autre des grilles des transistors haute tension où la région 5/7 peu dopée et peu profonde doit rester en place. On notera d'ailleurs que cet inconvénient s'aggrave dans le cadre de technologies submicroniques dans lesquelles les régions peu dopées sont particulièrement peu profondes.

Un autre inconvénient de ce procédé est que le masque de définition des zones siliciurées n'est pas, au niveau des transistors haute tension, auto-aligné sur les régions 11/13 de reprise de contact de source/drain.

Un objet de la présente invention est de prévoir un procédé de fabrication de transistors MOS haute et basse tension sur un même substrat semiconducteur qui pallie ces inconvénients.

Un autre objet de la présente invention est de prévoir un procédé de fabrication de transistors MOS haute et basse tension sur un même substrat semiconducteur qui soit plus simple à mettre en oeuvre, moins coûteux et qui réduise le nombre d'étapes de fabrication.

Pour atteindre ces objets, la présente invention prévoit un procédé de fabrication de circuits intégrés comportant des transistors MOS haute et basse tension de même type, ce procédé comportant les étapes consistant à former des structures de grilles isolées, à former des régions de drain/source faiblement dopées, à déposer une couche isolante pleine plaque, et comportant en outre les étapes suivantes :
1) former un masque, au-dessus, et en débordement latéral, des grilles des transistors haute tension ;
2) graver la couche isolante de façon à laisser des espaceurs sur les bords des grilles des transistors basse tension ;
3) implanter un dopant adapté à former des régions de contact de drain/source fortement dopées des transistors haute et basse tension ; et
4) former de façon auto-alignée une couche de siliciure métallique sur les régions de contact drain/source de tous les transistors, ainsi que sur les contacts de grille des transistors basse tension.

Selon un mode de réalisation de la présente invention, la séquence des étapes 1) à 3) est mise en oeuvre deux fois, une pour chaque série de transistors MOS d'un type de conductivité donné.

Selon un mode de réalisation de la présente invention, aux étapes 2) et 3), on laisse en place des zones d'oxyde dans des régions choisies.

Selon un mode de réalisation de la présente invention, le procédé s'applique à des filières technologiques dans lesquelles la dimension minimum d'un motif est inférieure à 1 µm.

Ces objets, caractéristiques et avantages, ainsi que d'autres de la présente invention seront exposés en détail dans la description suivante d'un mode de réalisation particulier faite à titre non limitatif en relation avec les figures jointes parmi lesquelles :
les figures 1 à 9 illustrent des étapes successives d'un procédé classique de fabrication de transistors CMOS haute et basse tension ; et
les figures 10 à 12 illustrent des étapes successives d'un procédé selon la présente invention de fabrication de transistors CMOS haute et basse tension.

Par souci de clarté, comme cela est habituel dans la représentation des circuits intégrés, les différentes figures ne sont pas à l'échelle. De plus de mêmes éléments sont désignés par de mêmes références.

Les étapes initiales du procédé selon l'invention sont identiques à celles décrites en relation avec les figures 1 à 4.

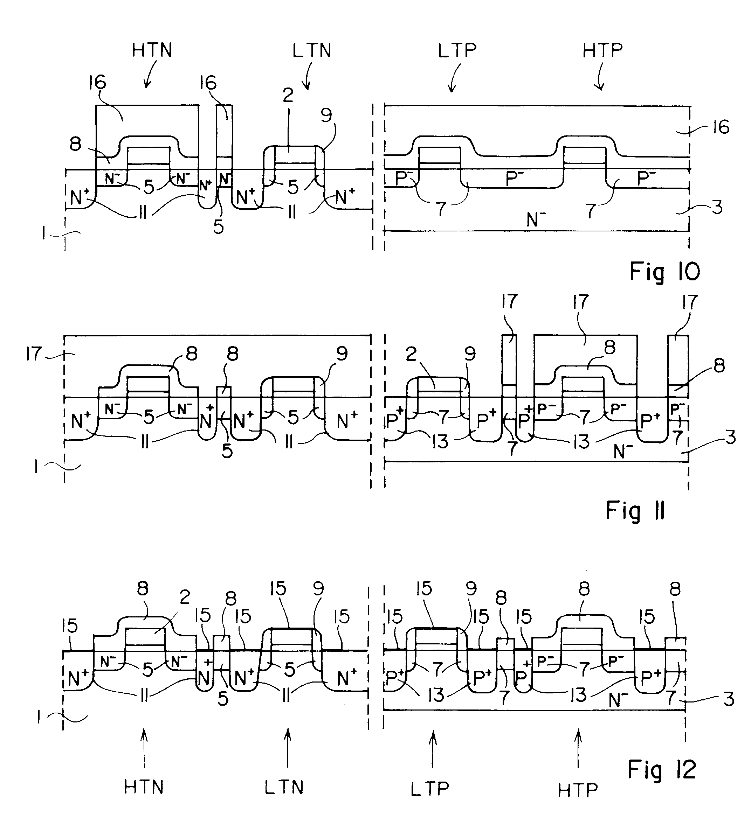

Ensuite, comme le représente la figure 10, au lieu de graver directement la couche d'oxyde 8 pour former des espaceurs tant autour des grilles des transistors basse tension qu'autour des grilles des transistors haute tension, on procède d'abord à une étape de masquage. On commence par former un premier masque 16, identique au masque 10 de la figure 6. On grave ensuite la couche d'oxyde 8 à travers les ouvertures de ce masque. Après quoi on réalise un dopage de type N à forte dose pour former les régions de prise de contact de drain/source des transistors à canal N haute et basse tension.

Ensuite, comme le représente la figure 11, on forme un second masque 17, identique au masque 12 de la figure 7. On grave ensuite la couche d'oxyde 8 à travers les ouvertures de ce masque. Après quoi on réalise un dopage de type P à forte dose pour former les régions de prise de contact de drain/source des transistors à canal P haute et basse tension.

Ensuite, comme le représente la figure 12, après avoir enlevé le dernier masque 17, on réalise une siliciuration des contacts.

Un premier avantage de la présente invention est qu'on ne grave plus de couche d'oxyde au-dessus de portions faiblement dopées des régions de drain et de source qui seront conservées, mais seulement au-dessus des portions de ces régions dans lesquelles seront effectuées des implantations destinées à les doper fortement.

Un autre avantage de la présente invention est qu'elle comporte moins d'étapes que le procédé classique. En effet, elle ne comprend qu'une étape de dépôt et de gravure d'une couche d'oxyde. La couche d'oxyde 14 de la figure 8 n'existe plus dans le procédé de l'invention.

Un autre avantage de la présente invention est que les premier et second masques selon l'invention (16 et 17 en figures 10 et 11) ont le même dessin que les troisième et quatrième masques (10 et 12 en figures 6 et 7) du procédé classique.

Un autre avantage de la présente invention est que la siliciuration illustrée en figure 12 est auto-alignée sur les régions où ont été formées les zones fortement dopées de prise de contact de drain/source.

Bien entendu, la présente invention est susceptible de diverses variantes et modifications qui apparaîtront à l'homme de l'art. En particulier, bien que la présente invention ait été décrite dans le cas de la fabrication simultanée de transistors à canal N et à canal P, elle s'applique également, encore plus simplement, à la formation sur un même substrat de transistors MOS haute et basse tension d'un seul type de conductivité.

Par ailleurs, la couche isolante d'oxyde 8 peut être remplacée par une structure multicouche.

## Revendications

1. Procédé de fabrication de circuits intégrés comportant des transistors MOS haute et basse tension (HTN, LTN ; HTP, LTP) de même type, comportant les étapes consistant à :
former des structures de grilles isolées (2) ;
former des régions de drain/source faiblement dopées (5 ; 7)
déposer une couche isolante (8) pleine plaque ;
caractérisé en ce qu'il comporte les étapes suivantes :
1) former un masque (16 ; 17), au-dessus, et en débordement latéral, des grilles des transistors haute tension ;
2) graver la couche isolante (8) de façon à laisser des espaceurs (9) sur les bords des grilles des transistors basse tension ;
3) implanter un dopant adapté à former des régions (11 ; 13) de contact de drain/source fortement dopées des transistors haute et basse tension ; et
4) former de façon auto-alignée une couche de siliciure métallique (15) sur les régions de contact drain/source de tous les transistors, ainsi que sur les contacts de grille des transistors basse tension.

2. Procédé selon la revendication 1 de formation de transistors haute et basse tension de types complémentaires, caractérisé en ce que la séquence des étapes 1) à 3) est mise en oeuvre deux fois, une pour chaque série de transistors MOS d'un type de conductivité donné.

3. Procédé selon la revendication 1, caractérisé en ce qu'aux étapes 2) et 3) on laisse en place des zones d'oxyde dans des régions choisies.

4. Procédé selon une des revendications 1 à 3, caractérisé en ce qu'il s'applique à des filières technologiques dans lesquelles la dimension minimum d'un motif est inférieure à 1 µm.
